# EUROPEAN PATENT APPLICATION

(11) **EP 1 650 605 A1**
(43) Date of publication of application: **26.04.2006**
(21) Application number: 04745562.1
(22) Date of filing: 03.06.2004
(51) Int. Cl.: G03F 7/32

(54) **DEVELOPING SOLUTION FOR PHOTOSENSITIVE COMPOSITION AND METHOD FOR FORMING PATTERNED RESIST FILM**

(30) Priority: 14.07.2003 JP 2003196451
(71) Applicant: AZ Electronic Materials USA Corp., Somerville, NJ 08876 (US)
(72) Inventor: NAGAHARA, Tatsuro, c/o Electronic Materials K.K., Ogasa-gun, Shizuoka 4371412 (JP); MUTOH, Tadashi, c/o Clariant (Japan) K.K., Shizuoka 437-1496 (JP); HAYASHI, Masanobu, c/o Electronic Materials K.K., Ogasa-gun, Shizuoka 4371412 (JP)
(74) Representative: Isenbruck, Günter
(86) International application number: PCT/JP2004/007706
(87) International publication number: WO 2005/006083

(57) **Abstract**

There are provided a developing solution, which can develop a photosensitive composition in a simple manner while maintaining satisfactory sensitivity and resolution, and a method for pattern formation using said developing solution. This developing solution comprises a compound containing a hydrophilic group(s) selected from the group consisting of an amine-N-oxide group, a sulfonate group, a sulfate group, a carboxylate group, and a phosphate group, and is particularly suitable for use in the development of a photosensitive composition comprising a silicon-containing polymer. The present invention also relates to a method for pattern formation using the developing solution.

## Description

### TECHNICAL FIELD

The present invention relates to a developing solution for use in the development of a photosensitive composition, and a method for pattern formation using the same.

### BACKGROUND ART

It is well known that positive-working or negative-working photoresists have been used for microfabrication or patterning in various fields including the manufacture of semiconductor devices or liquid crystal display devices. Various photoresists including a positive-working photosensitive composition comprising a novolak resin and a quinone diazide photosensitizer, a chemical amplification-type positive-working or negative-working photosensitive composition, a polyvinyl cinnamate photosensitive composition, a bisazide-rubber photosensitive composition, and a negative-working resist such as photopolymerization-type photosensitive composition have hitherto been used as such conventional photoresists. Depending upon purposes of use, various properties are required of such photoresists. For example, in the fabrication of semiconductor devices, properties such as high sensitivity, high resolution, and etching resistance are required.

On the other hand, in the manufacture of semiconductor devices, liquid crystal display devices, printed circuit boards and the like, various elements including interlayer dielectric films are patterned. These elements are exposed to a high temperature above 400°C, for example, in a manufacturing process (for example, a process of vapor deposition of wiring by CVD) of semiconductor devices or the like. Accordingly, organic materials are not satisfactory as materials for interlayer dielectric films or the like exposed to high temperatures from the viewpoint of heat resistance, and the use of inorganic materials has been desired. Regarding such inorganic materials, silica ceramic films have been used as useful patterning films, for example, in semiconductor devices, liquid crystal display devices, and printed circuit boards, because they are excellent in heat resistance, as well as in abrasion resistance, corrosion resistance, insulating properties, transparency and the like.

The above patterned silica ceramic film is generally formed by etching a ceramic film using a patterned photoresist as an etching mask. On the other hand, for example, a method for ceramic film pattern formation has been proposed (patent document 1). This method comprises, for example, coating a coating liquid containing a polysilizane onto a substrate to form a coating film, exposing the coating film pattern-wise to ultraviolet light under an oxidizing atmosphere to cure the ultraviolet light exposed areas, then removing ultraviolet light unexposed areas, then converting the patterned polysilazane film to a ceramic film to form a ceramic film pattern.

Regarding fabrication of semiconductor devices or the like, there is an ever-increasing demand for a higher level of microfabrication. To this end, a material, which is of a high resolution positive-working type and a high level of etching resistance such as oxygen plasma resistance, is desired as the resist type. Further, when the patterned film is allowed to stay for use as an interlayer dielectric film, the film material should satisfy, in addition to requirements associated with the microfabrication, various property requirements, for example, for high levels of heat resistance, low permittivity, and transparency required in the interlayer dielectric film.

In order to meet the above demand, the present inventors have proposed a method in which a patterned polysilazane film is formed using a photosensitive polysilazane composition comprising a polysilazane and a photoacid generating agent and is further allowed to stand or sintered in an ambient atmosphere to convert the polysilazane film to a silica ceramic film (patent documents 2 and 3). In this method, the Si-N bond in the polysilazane is cleaved by an acid generated in the exposed areas of the photosensitive polysilazane composition film, a silanol (Si-OH) bond is formed as a result of a reaction with H₂O molecules, resulting in the decomposition of the polysilazane. Regarding this proposed method, there is a description to the effect that, for the decomposition of the polysilazane, the exposed photosensitive polysilazane composition film is brought into contact with water.

In these methods, however, probably for the reason that the decomposition of the polysilazane proceeds only around the surface of the film of the photosensitive polysilazane composition, when the decomposition treatment is carried out under some decomposition treatment conditions, the exposed areas cannot be satisfactorily removed in subsequent development with an aqueous alkali solution and, consequently, in some cases, a part of the exposed areas remains unremoved after the development in the pattern.

The present inventors have further made studies with a view to solving these problems and have proposed a method in which the exposed photosensitive polysilazane composition film is humidified in the decomposition treatment of the polysilazane (patent documents 4 and 5). According to this method, the polysilazane can be decomposed in a short time, and, further, any development residue does not stay in the pattern after the development.

Patent document 1: Japanese Patent Laid-Open No. 88373/1993
Patent document 2: Japanese Patent Laid-Open No. 181069/2000
Patent document 3: Japanese Patent Laid-Open No. 288270/2001
Patent document 4: Japanese Patent Laid-Open No. 72502/2002
Patent document 5: Japanese Patent Laid-Open No. 72504/2002

### DISCLOSURE OF THE INVENTION

### PROBLEMS TO BE SOLVED BY THE INVENTION

Unlike the conventional methods, however, this method needs the provision of the step of humidifying the exposed film and an apparatus for the humidification. In the actual production process, regarding the additional provision of this step and apparatus, there is room for improvement from the viewpoint of yield.

### MEANS FOR SOLVING THE PROBLEMS

In view of the above problems of the prior art,
the developing solution used in the development of the photosensitive composition according to the present invention is comprises a compound, containing at least one hydrophilic group selected from the group consisting of an amine-N-oxide group, a sulfonate group, a sulfate group, a carboxylate group, and a phosphate group, and water.

Further, the method for patterned photosensitive resist film formation according to the present invention comprises coating a photosensitive composition onto a substrate, exposing the coating, and developing the exposed coating to form a patterned resist film, characterized in that the developing is carried out with a developing solution comprising a compound, containing at least one hydrophilic group selected from the group consisting of an amine-N-oxide group, a sulfonate group, a sulfate group, a carboxylate group, and a phosphate group, and water.

### EFFECT OF THE INVENTION

According to the present invention, a resist pattern having excellent properties can be formed without using any special step and apparatus in the development of a photosensitive composition, particularly a photosensitive composition comprising a silicon-containing copolymer.

### BRIEF DESCRIPTION OF THE DRAWINGS

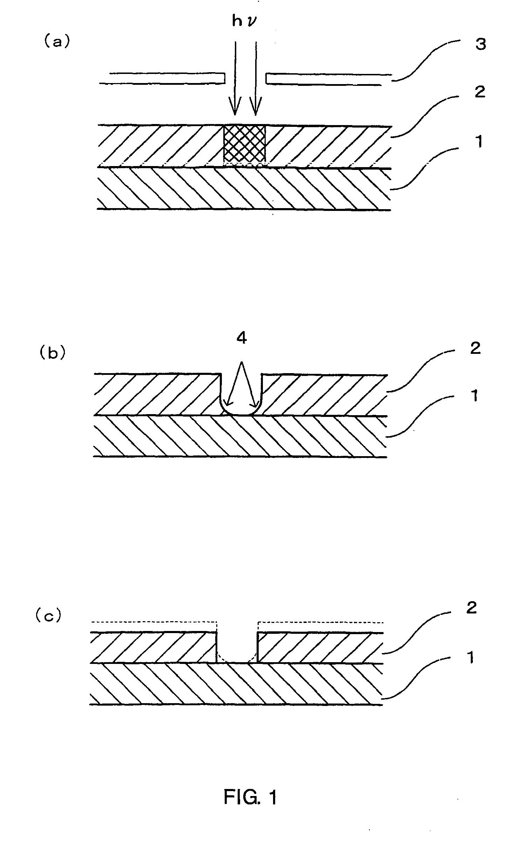

[Fig. 1] A conceptual diagram showing a development process according to the present invention.

### DESCRIPTION OF REFERENCE CHARACTERS

1 substrate
2 photosensitive composition
3 mask
4 scum

### BEST MODE FOR CARRYING OUT THE INVENTION

The developing solution used in the development of the photosensitive composition according to the present invention comprises a compound, containing at least one hydrophilic group selected from the group consisting of an amine-N-oxide group, a sulfonate group, a sulfate group, a carboxylate group, and a phosphate group, and water.

The compound containing at least one hydrophilic group selected from the group consisting of an amine-N-oxide group, a sulfonate group, a sulfate group, a carboxylate group, and a phosphate group can properly selected from compounds which do not sacrifice the effect of the present invention. In general, water soluble compounds are selected, and the developing solution per se is generally in the form of an aqueous solution.

Among these compounds, compounds represented by general formulae (I) to (V) are preferred.

R¹¹R¹²R¹³N→O (I)

R²SO₃M (II)

R³OSO₃M (III)

R⁴COOM (IV)

R⁵OPO₃M'₂ (V)

wherein
R¹¹, R¹², R¹³, R², and R⁴ each independently represent a substituted or unsubstituted alkyl, alkenyl or aryl group;
R³ and R⁵ represent a substituted or unsubstituted alkyl, alkenyl, aryl, polyoxyethylene alkyl or polyoxyethylene alkylphenyl group; and
M and M' represent basic group.

Compounds of general formula (I) are amine-N-oxide group-containing compounds. By virtue of the presence of the amine-N-oxide group, such compounds are generally soluble in water. In the present invention, preferably, R¹¹, R¹², and R¹³ each independently represent a substituted or unsubstituted alkyl, alkenyl or aryl group. In this case, at least one of R¹¹, R¹², and R¹³ more preferably represents a lipophilicity-imparting organic group. More specifically, the lipophilicity-imparting organic group is preferably an alkyl group having 2 to 26 carbon atoms, an alkenyl group having 2 to 26 carbon atoms, or an aryl group having 6 to 10 carbon atoms. Particularly preferred are alkylamine-N-oxide compounds in which at least one of R¹¹, R¹², and R¹³ represents an alkyl group. As with conventional surfactants, the compound containing a lipophilicity-imparting group comprises a hydrophilic group and a lipophilic group. Here R¹¹, R¹², and R¹³ are each independently selected and may if necessary be substituted by various substituents. Such substituents include alkyl, aryl and hydroxyl groups, halogen atoms, and amine-N-oxide, sulfonate, sulfate, carboxylate and phosphate groups. Specific examples of such compounds include lauryl dimethylamineoxide, lauryl amidepropylamineoxide, triethylamineoxide, and O←N(CH₃)₂-(CH₂)₁₂-(CH₃)₂N→O.

When the developing solution according to the present invention contains a compound containing an amine-N-oxide group, the concentration of the compound is preferably 0.005 to 2 mol/liter, and more preferably 0.01 to 1.5 mol/liter.

Among the compounds represented by general formula (I), compounds represented by general formula (Ia) are preferred.

R-(CH₃)₂N→O (Ia)

wherein R represents an alkyl group and is particularly preferably a straight-chain alkyl group having 6 to 22 carbon atoms. Lauryl dimethylamineoxide is particularly preferred.

Compounds represented by general formula (II) are sulfonate group-containing compounds. By virtue of the presence of the sulfonate group, such compounds are soluble in water. When the group R² is lipophilic, such compounds can be used as a surfactant. Preferably, the group R² represents an alkyl group having 2 to 26 carbon atoms, an alkenyl group having 2 to 26 carbon atoms, or an aryl group having 6 to 10 carbon atoms and may if necessary be substituted by an amide group, an amino group, a hydroxyl group, an amine-N-oxide group, a sulfonate group, a sulfate group, a carboxylate group, or a phosphate group.

M represents a basic group, and preferred examples thereof include alkali metals, for example, sodium and potassium, alkaline earth metals, for example, calcium and magnesium, and ammonium compounds, for example, ammonium. Other metals or organic basic compounds may also be used. When M represents a divalent or higher group, a carboxylic acid containing a plurality of functionalities may be attached to one basic group, or alternatively two or more monofunctional carboxylic acids may be attached to one basic group. Hydrogen is not included in the basic group M.

Such compounds include, for example, sodium, potassium, ammonium, and triethanolamine salts of alkylsulfonic acids, alkylarylsulfonic acids and the like. More specific examples thereof include disodium lauryl sulfosuccinate, sodium dodecylbenzenesulfonate, and sodium lauroylsarcosine. In the present invention, alkylsulfonate compounds are preferred as such compounds.

Compounds represented by general formula (III) are sulfonate group-containing compounds. By virtue of the presence of the sulfonate group, such compounds are soluble in water. When the group R³ is lipophilic, such compounds may be used as a surfactant. The group R³ represents a substituted or unsubstituted alkyl, alkenyl, aryl, polyoxyethylenealkyl, or polyoxyethylenealkylphenyl group, preferably an alkyl group having 2 to 26 carbon atoms, an alkenyl group having 2 to 26 carbon atoms, or an aryl group having 6 to 10 carbon atoms, or a polyoxyethylenealkyl or polyoxyethylenealkylphenyl group in which the degree of polymerization of the oxyethylene group is 1 to 30 and the alkyl group has 2 to 26 carbon atoms, and may if necessary be substituted by an amide group, an amino group, a hydroxyl group, an amine-N-oxide group, a sulfonate group, a sulfate group, a carboxylate group, or a phosphate group.

M represents a basic group and is as defined in the compound of general formula (II).

Such compounds include sodium, potassium, ammonium, and triethanolamine salts of alkylsulfonic acids, polyoxyethylene alkyl ether sulfonic acids, polyoxyethylene alkylphenyl ether sulfonic acids, and the like. More specific examples thereof include sodium laurylsulfate, triethanolamine laurylsulfate, ammonium laurylsulfate, and sodium polyoxyethylene alkyl ether sulfates.

Compounds represented by general formula (IV) are carboxylate group-containing compounds. By virtue of the presence of the carboxylate group, such compounds are soluble in water. When the group R⁴ is lipophilicic, such compounds can be used as a surfactant. Preferably, the group R⁴ represents an alkyl group having 2 to 26 carbon atoms, an alkenyl group having 2 to 26 carbon atoms, or an aryl group having 6 to 10 carbon atoms and may if necessary be substituted by an amide group, an amino group, a hydroxyl group, an amine-N-oxide group, a sulfonate group, a sulfate group, a carboxylate group, or a phosphate group.

M represents a basic group and is as defined in the compound of general formula (II).

Such compounds include alkali salts of higher fatty acids, for example, ammonium laurate, sodium laurate, sodium palmitate, potassium stearate, and ammonium oleate, and salts of acylated amino acids, for example, sodium N-lauroyl-glutamate, triethanolamine N-lauroyl-glutamate, sodium N-cocoyl-N-methyltaurine, sodium lauroylsarcosine, sodium lauroylmethyltaurine, sodium lauroylmethyl-β-alanine, and ammonium N-lauroyl-glutamate.

Compounds represented by general formula (V) are phosphate group-containing compounds. By virtue of the presence of the phosphate group, such compounds are soluble in water. When the group R⁵ is lipophilic, such compounds can be used as a surfactant. The group R⁵ represents a substituted or unsubstituted alkyl, alkenyl, aryl, polyoxyethylenealkyl, or polyoxyethylenealkylphenyl group, preferably an alkyl group having 2 to 26 carbon atoms, an alkenyl group having 2 to 26 carbon atoms, or an aryl group having 6 to 10 carbon atoms, or a polyoxyethylenealkyl or polyoxyethylenealkylphenyl group in which the degree of polymerization of the oxyethylene group is 1 to 30 and the alkyl group has 2 to 26 carbon atoms, and may if necessary be substituted by an amide group, an amino group, a hydroxyl group, an amine-N-oxide group, a sulfonate group, a sulfate group, a carboxylate group, or a phosphate group.

M' represents a basic group and is as defined in the compound of general formula (II), provided that the basic group M' contains hydrogen.

Such compounds include sodium, potassium, ammonium, and triethanolamine salts of alkylphosphoric acids, polyoxyethylene alkyl ether phosphoric acids, polyoxyethylene alkylphenyl ether phosphoric acids and the like, and more specific examples thereof include sodium polyoxyethylene alkyl ether phosphates, and sodium polyoxyethylene alkylphenyl ether phosphates.

Preferably, the hydrophilic group-containing compound further contains at least one group selected from the group consisting of amine-N-oxide, sulfonate, sulfate, carboxylate, and phosphate groups. The present invention that contains above-mentioned hydrophilic compounds can achieve excellent developing properties without additional humidification step, particularly in the development of a photosensitive composition involving silicon-containing copolymer. In other words, the use of the developing solution according to the present invention can reduce the necessary number of steps by reducing the step of humidification in the development of the photosensitive composition containing a silicon-containing polymer.

In the present invention, preferably, the content of the compound, containing at least one hydrophilic group selected from the group consisting of amine-N-oxide, sulfonate, sulfate, carboxylate, and phosphate groups, in the developing solution is 0.005 mol/liter from the viewpoint of developing the effect of the present invention. On the other hand, in order to maintain the viscosity of the developing solution value at a low value, the content of this compound in the developing solution is preferably not more than 2 mol/liter. Specifically, in the present invention, the content of these compounds in the developing solution is preferably 0.005 to 2 mol/liter, more preferably 0.01 to 1.5 mol/liter. Even when a compound containing two or more hydrophilic groups selected from the group consisting of amine-N-oxide, sulfonate, sulfate, carboxylate, and phosphate groups is used, preferably, the above hydrophilic group-containing compound is used in the above-defined amount range.

The hydrophilic group-containing compound used in the developing solution according to the present invention is particularly preferably an alkylamine-N-oxide compound or an alkyl sulfonate compound. The use of developing solutions containing these compounds according to the present invention can achieve excellent developing properties without the need to additionally provided the step of humidification particularly in the development of a photosensitive composition containing a silicon-containing copolymer.

The developing solution according to the present invention comprises the above compound containing at least one hydrophilic group and water. In general, the developing solution according to the present invention is in the form of an aqueous solution prepared by dissolving the above compound in water. However, the developing solution according to the present invention may be in the form of a dispersion depending upon conditions such as the type of the compound, optionally used other additives, pH of the developing solution and the like.

The addition of an acid to the developing solution according to the present invention can reduce the residue or scum of the photosensitive composition in the developed substrate.

This effect is significant when the photosensitive composition contains a silicon-containing copolymer, particularly a polysilazane compound. This is considered attributable to the fact that, in an acidic aqueous solution, water-soluble sites are produced in the silicon-containing copolymer and, consequently, the copolymer is eluted. An embodiment in which the photosensitive composition contains a polysilazane will be described below with reference to Fig. 1.

The photosensitive material comprising a photosensitive composition 2 coated on a substrate 1 is exposed through a mask 3. When this exposed photosensitive material is developed, in some cases, scum 4 occurs. The formation of such scum results in deteriorated resolution.

When the photosensitive composition contains a polysilazane compound, lowering the pH value of the developing solution increases the capability of dissolving the resist composition. The reason for this is considered to reside, for example, in that, when hydrochloric acid is added to the developing solution, the following reaction takes place leading to the enhanced capability of dissolving the resist composition.

-SiHMe-NH- + Cl⁻ → -SiHMeCl + NH₂-

-SiHMeCl + H₂O → -SiHMeOH + Cl⁻ + H⁺

Accordingly, it is considered that when the pH value of the developing solution is lowered, by virtue of the enhanced capability of dissolving the resist composition, the surface of the resist composition is ,as shown in Fig. 1 (c), evenly dissolved and consequently scum is not formed. The developing solution according to the present invention may be used in any pH region ranging from the acidic region to the alkaline region. However, the present invention can achieve further improved developing properties in a pH region ranging from the neutral region to the acidic region, particularly in the acidic pH region.

Organic acids or inorganic acids may be used as the acid added to the developing solution. Specific examples thereof include citric acid, hydrochloric acid, pivalic acid, acetic acid, phosphoric acid, phthalic acid and the like.

Further, in the development, a buffering agent may be added in order to maintain the pH value at a constant value. The buffering agent may be properly selected depending upon the acid used and other conditions such as ingredients contained in the developing solution. Specific examples thereof include ammonium acetate, ammonium citrate, potassium phthalate, potassium chlorate, sodium phosphate, and dibasic sodium phosphate.

The developing solution according to the present invention may if necessary contain other additives. Such additive include antifoaming agents. In particular, some of the hydrophilic group-containing compounds according to the present invention have properties close to properties of surfactants. In this case, in some cases, a high level of foaming properties are developed depending upon these compounds, and, thus, the addition of an antifoaming agent is preferred. Preferred antifoaming agents include perfluoroalkylphosphoric amides, glycerin fatty acid esters, and silicone resin antifoaming agents.

The developing solution according to the present invention can be used in the development of any proper photosensitive composition. Such photosensitive compositions include those containing a novolac resin, a polyimide resin, a polyhydroxystyrene resin, an acrylic resin or the like. The developing solution according to the present invention is preferably used in the development of a photosensitive resist resin containing a silicon-containing polymer. Silicon-containing polymers include polysilazanes, polysilanes, or polymers described in Japanese Patent Laid-Open No. 311591/2002, and those containing a polysilazane compound are particularly preferred. When the developing solution according to the present invention is used in the development of the polysilazane compound-containing photosensitive composition, satisfactory sensitivity and resolution can be realized.

The development method is not particularly limited and may be commonly used one. Specific examples thereof include dipping, spraying, and paddling.

Regarding the temperature of the development, the development can be carried out so far as the developing solution is not frozen. The temperature of the developing solution, however, is generally from 20 to 70°C. The temperature of the developing solution may vary depending upon the type of the photosensitive composition to be developed and applications. When the temperature of the developing solution is low, in general, the surface of the unexposed area after the development is kept smooth and, thus, damage is likely to be reduced. On the other hand, when the temperature of the developing solution is high, the sensitivity is likely to be enhanced. From this viewpoint, the temperature of the developing solution is preferably from 20 to 60°C, more preferably from 20 to 50°C. The reason why the sensitivity is enhanced by raising the temperature of the developing solution is believed to reside in that, when the temperature of the developing solution is raised, the rate of the chemical reaction between the resist exposed part and the developing solution is increased and the dissolution of the product produced in this reaction in the developing solution is promoted. When the temperature of the developing solution is raised to enhance the sensitivity, the development can be carried out even when the thickness of the resist film is increased. In this case, for example, a resist film having a film thickness of not less than 3 µm can be developed. Methods usable for bringing the temperature of the developing solution to the above-defined temperature range include a method in which a development tank or a developing solution tank for storing the developing solution is cooled or heated, or a method in which a heating or cooling mechanism is provided in a developing solution feed line.

Example 1
A PGMEA solution of a photosensitive polysilazane (solid content 20%) was spin coated (speed of rotation: 2000 rpm) onto a silicon wafer, and the coated wafer was then heated on a hot plate of 110°C for one min to form a 0.7 µm-thick film.

This film was exposed with a stepper (LD-5015iCW, manufactured by Hitachi, Ltd.) (up to 50 mJ, step 5 mJ) while varying positions.

The exposed substrate thus obtained was developed with a developing solution at room temperature (about 23°C). The developing solution used was one prepared by dissolving the compound described in Table 1 in water. For comparison, development was carried out with an aqueous 2.38% TMAH solution (MIF-300, manufactured by Clariant Japan), a conventional developing solution (Comparative Example 1-1). Further, an experiment was also carried out in accordance with patent document 4 wherein the step of humidifying the coating in an atmosphere of 25°C and 80%RH for 5 min was added before the development with the aqueous 2.38% TMAH solution (Comparative Example 1-2).

[Table 1]

**Table 1**

| | Compound | Compound concentration, wt% | Sensitivity | Resolution |
|---|---|---|---|---|
| Ex. 1-1 | Lauryldimethylamine oxide | 5 | ○ | ○ |
| Ex. 1-2 | Lauryldimethylamine oxide | 20 | ○ | ○ |
| Ex. 1-3 | Trimethylamine oxide | 5 | ○ | ○ |
| Ex. 1-4 | Laurylamidepropy I-amine oxide | 5 | ○ | ○ |
| Ex. 1-5 | Disodium lauryl sulfosuccinate | 2 | Δ | ○ |
| Ex. 1-6 | Sodium dodecylbenzenesulfonate | 5 | ○ | Δ |
| Ex. 1-7 | Ammoniumpolyoxyethylene lauryl ether sulfonate | 10 | ○ | ○ |
| Ex. 1-8 | Tris(monochloropropyl)phosphate | 20 | ○ | ○ |
| Comp. Ex. 1-1 | TMAH | 2.38 | X | X |
| Comp. Ex. 1-2 | TMAH | 2.38 | ○ | ○ |

Conditions for evaluation in the table were as follows.
○: Excellent sensitivity or resolution
Δ: Satisfactory sensitivity or resolution from a practical viewpoint
x: Poor sensitivity or resolution on such a level that cannot be measured.

Example 2
Citric acid (6 mol%) and 6 mol% of ammonium acetate as a buffer agent were added to the developing solution of Example 1-1. The developing solution thus obtained had a pH value of 5.0. The above exposed substrate was developed with this developing solution at room temperature (about 23°C). As a result, scum was reduced, and the resolution could be further improved.

Example 3
Citric acid (2 mol%) and 2% by weight of a modified silicone (tradename ANTIFORM E-20 (manufactured by Kao Corp.)) as an antifoaming agent were added to the developing solution of Example 1-1. The above exposed substrate was developed with this developing solution at room temperature (about 23°C). As a result, scum was reduced, and the resolution could be further improved.

Example 4
A 5% aqueous solution (50 g) of lauryldimethylamine oxide was placed in a 100-cc glass bottle and was vigorously stirred. As a result, foaming took place. When this glass bottle was allowed to stand, 10 min after the initiation of standing, foams disappeared.

On the other hand, 50 g of an aqueous solution prepared by adding 0.05% by mole of a perfluoroalkylphosphoric amide as an antifoaming agent to a 5% aqueous solution of lauryldimethylamine oxide was placed in a 100-cc glass bottle and was vigorously stirred. As a result, foaming did not substantially take place.

**Example 5**
Methyltrimethoxysilane (150 g) as an alkylalkoxysilane, 1 g of diisopropoxytitanium bisethylacetyl acetate (purity 78%) as a metal chelate compound and 500 g of propylene glycol monopropyl ether as an organic solvent were mixed together, and the mixture was then heated to 70°C. While stirring the reaction mixture with a stirrer, a mixture of 50 g of ion exchanged water with 50 g of propylene glycol monopropyl ether was added at 60°C over a period of one hr. Further, a reaction was allowed to proceed for 10 hr while maintaining the temperature at 60°C. Subsequently, 50 g of acetyl acetone was added, and the reaction mixture was then concentrated under the reduced pressure at 40°C. The concentrate was diluted with propylene glycol monopropyl ether to regulate the solid content to 15% by weight. Triphenylsulfonium triflate as a photoacid generating agent was added to this solution so that the concentration of the triphenylsulfonium triflate was 2% by weight based on the solid content of the solution. Further, t-butoxycarbonyloxymethyltricyclodecane as a dissolution inhibitor was added so that the concentration of this dissolution inhibitor was 20% by weight based on the solid content of the solution. The copolymer contained in this solution was a silicon-containing polymer containing a siloxane bond.

This solution was coated onto a silicon wafer by spin coating at 1500 rpm. The thickness of the coating thus obtained was about 0.4 µm. Subsequently, the coating was prebaked on a hot plate under conditions of 70°C/60 sec. The film on the wafer thus formed was exposed to ultraviolet light by a KrF excimer stepper, followed by heating under conditions of 90°C/60 sec.

The exposed wafer was developed with an aqueous solution containing 5% by weight of lauryldimethylamine oxide. As a result, only the ultraviolet light exposed areas could be removed to form a pattern. The sensitivity and resolution each were on a level that was satisfactory from a practical viewpoint.

Example 6
A PGMEA solution of a photosensitive polysilazane (solid content 50%) was spin coated (rotating speed: 1500 rpm) onto a silicon wafer. The coated wafer was then heated on a hot plate of 100°C for 2 min to form a 3.5 µm-thick film.

Three substrates with a film as prepared above were provided and were exposed with a stepper (up to 150 mJ, step 5 mJ) while varying positions.

The exposed substrates thus obtained were developed with a developing solution. In this case, an aqueous lauryldimethylamine oxide solution (1.5% by weight) was used as the developing solution, and the development was carried out with the temperature of the developing solution varied from 10°C to 75°C. The results were as shown in Table 2.
[Table 2]

**Table 2**

| | Development solution temp. | Sensitivity | Surface state of unexposed areas |
|---|---|---|---|
| Ex. 6-1 | 10°C | 800 mJ/cm² | ○ |
| Ex. 6-2 | 23°C | 200 mJ/cm² | ○ |
| Ex. 6-3 | 40°C | 20 mJ/cm² | ○ |
| Ex. 6-4 | 60°C | 17 mJ/cm² | ○ |
| Ex. 6-5 | 70°C | 17 mJ/cm² | ○ |
| Ex. 6-6 | 75°C | 15 mJ/cm² | Δ |

Evaluation criteria for the surface state of unexposed areas are as follows.
○: Good
Δ: Film surface in a somewhat rough state that, however, was on a level which did not pose a practical problem
x: Film surface in a rough state on a level which rendered the use of the product practically unusable

Example 7
Substrates with a film were provided in the same manner as in Example 6, and development was carried out with an aqueous myristyldimethylamine oxide solution (10% by weight) at 35°C. Separately, 2% by mole of a glycerin fatty acid ester as an antifoaming agent was added to this developing solution, and development was carried out in the same manner as described just above. The results were as shown in Table 3.
[Table 3]

**Table 3**

| | Antifoaming agent | Resolution | Foams formed during stirring of developing solution |
|---|---|---|---|
| Ex. 7-1 | Not used | Good | Significant |
| Ex. 7-2 | Used | Good | Few |

## Claims

1. A developing solution for use in the development of a photosensitive composition, **characterized by** comprising a compound, containing at least one hydrophilic group selected from the group consisting of an amine-N-oxide group, a sulfonate group, a sulfate group, a carboxylate group, and a phosphate group, and water.

2. The developing solution according to claim 1, wherein said photosensitive composition comprises a silicon-containing copolymer.

3. The developing solution according to claim 1 or 2, wherein said hydrophilic group-containing compounds are represented by general formulae (I) to (V):
R¹¹R¹²R¹³N→O (I)
R²SO₃M (II)
R³OSO₃M (III)
R⁴COOM (IV)
R⁵OPO₃M'₂ (V)
wherein
R¹¹, R¹², R¹³, R², and R⁴ each independently represent a substituted or unsubstituted alkyl, alkenyl or aryl group;
R³ and R⁵ represent a substituted or unsubstituted alkyl, alkenyl, aryl, polyoxyethylene alkyl or polyoxyethylene alkylphenyl group; and
M and M' represent basic group.

4. The developing solution according to any one of claims 1 to 3, wherein said hydrophilic group-containing compound further comprises at least one group selected from the group consisting of an amine-N-oxide group, a sulfonate group, a sulfate group, a carboxylate group, and a phosphate group.

5. The developing solution according to any one of claims 1 to 4, which further comprises an antifoaming agent.

6. The developing solution according to any one of claims 1 to 5, wherein the content of the compound containing at least one hydrophilic group selected from the group consisting of an amine-N-oxide group, a sulfonate group, a sulfate group, a carboxylate group, and a phosphate group is 0.005 to 2 moles/liter in total.

7. The developing solution according to any one of claims 2 to 6, wherein said silicon-containing copolymer contains a silazane bond.

8. The developing solution according to any one of claims 1 to 7, wherein the temperature is from 20 to 70°C.

9. A method for patterned photosensitive resist film formation, comprising coating a photosensitive composition onto a substrate, exposing the coating, and developing the exposed coating to form a patterned resist film, **characterized in that** the developing is carried out with a developing solution comprising a compound, containing at least one hydrophilic group selected from the group consisting of an amine-N-oxide group, a sulfonate group, a sulfate group, a carboxylate group, and a phosphate group, and water.

10. The method for patterned photosensitive resist film formation according to claim 9, wherein the temperature of the developing solution is from 20 to 70°C.
